## Europäisches Patentamt
## European Patent Office
## Office européen des brevets

(19)

(11) Veröffentlichungsnummer: **0 146 652**
**B1**

(12)

# EUROPÄISCHE PATENTSCHRIFT

(45) Veröffentlichungstag der Patentschrift:
02.09.87

(51) Int. Cl.⁴: **H 03 D 3/00**, H 04 L 27/14

(21) Anmeldenummer: **83113112.3**

(22) Anmeldetag: **24.12.83**

(54) Digitaler FM-Demodulator für digitalisierte FM-Signale.

(43) Veröffentlichungstag der Anmeldung:
03.07.85 Patentblatt 85/27

(45) Bekanntmachung des Hinweises auf die Patenterteilung:
02.09.87 Patentblatt 87/36

(84) Benannte Vertragsstaaten:
DE FR NL

(56) Entgegenhaltungen:
EP-A-0 066 229
EP-A-0 099 142
WO-A-83/01159

(73) Patentinhaber: **Deutsche ITT Industries GmbH,
Hans- Bunte- Strasse 19 Postfach 840, D-7800
Freiburg (DE)**
(84) Benannte Vertragsstaaten: **DE**

(73) Patentinhaber: **ITT INDUSTRIES INC., 320 Park
Avenue, New York, NY 10022 (US)**
(84) Benannte Vertragsstaaten: **FR NL**

(72) Erfinder: **Zähringer, Edmund, Dipl.- Ing.,
Industriestrasse 2, D-7812 Bad Krozingen (DE)**
Erfinder: **Baker, Peotr, Fishpond House Park Road,
Allington Lincolnshire (GB)**
Erfinder: **Zettel, Rolf, Dipl.- Ing., Berliner Strasse
66, D-7809 Denzlingen (DE)**

(74) Vertreter: **Morstadt, Volker, Dipl.- Ing., c/o
Deutsche ITT Industries GmbH
Patent/Lizenzabteilung Postfach 840 Hans- Bunte-
Strasse 19, D-7800 Freiburg/Brsg. (DE)**

EP 0 146 652 B1

**Beschreibung**

Die Erfindung betrifft einen digitalen FM-Demodulator für mittels eines ersten Abtastsignals digitalisierte FM-Signale.

Eines der üblichen analogen Verfahren zur FM-Demodulation besteht darin, nach Bandfilterung des analogen FM-Signals mittels eines analogen Nulldurchgangs-Detektors den Zeitpunkt der Nulldurchgänge zu bestimmen und zum jeweiligen Zeitpunkt positiv und/oder negativ gerichteter Nulldurchgänge ein Monoflop zu triggern, das Ausgangsimpulse mit konstanter Amplituden-Zeit-Fläche erzeugt, und schließlich diese Impulse mittels eines Integrationsglieds bzw. durch Tiefpaßfilterung aufzusummieren, an dessen Ausgang das demodulierte Signal auftritt.

Die allgemeine Aufgabe der in den Ansprüchen angegebenen Erfindung besteht darin, dieses bei analogen FM-Demodulatoren übliche Prinzip bei der digitalen FM-Demodulation anzuwenden, d.h. ein bereits digitalisiertes und ggf. digital bandbegrenztes FM-Signal rein digital so weiterzuverarbeiten, daß am Ausgang des digitalen FM-Demodulators das demodulierte Signal in digitaler Form vorliegt.

Ein Vorteil der Erfindung besteht somit bereits in der Aufgabenlösung selbst. Ein weiterer Vorteil ist darin zu sehen, daß ausschließlich digitale Teilschaltungen bei der Realisierung erforderlich sind und daß somit eine Integrierung in der Technik integrierter Feldeffekt-Isolierschicht-Transistorschaltungen (MOS-Technik) besonders günstig ist. Weitere Vorteile ergeben sich aus der nun folgenden Beschreibung der Erfindung anhand der Figuren der Zeichnung.

Fig. 1 zeigt das Blockschaltbild eines Ausführungsbeispiels der Erfindung,

Fig. 2 bis 6 zeigen verschiedene der Funktionserläuterung dienende Kurvenbilder,

Fig. 7 zeigt das Schaltschema eines Ausführungsbeispiels des bei der Erfindung vorgesehenen Interpolations-Filters,

Fig. 8 zeigt das Blockschaltbild eines möglichen Ausführungsbeispiels für die bei der Erfindung verwendeten Nulldurchgangsdetektoren und gruppenlaufzeit-gesteuerten digitalen Monoflops,

Fig. 9 zeigt das Filterschaltbild eines Ausführungsbeispiels des bei der Erfindung eingesetzten Konversionsfilters, und

Fig. 10 zeigt das Filterschaltbild eines anderen Ausführungsbeispiels für das Konversionsfilter.

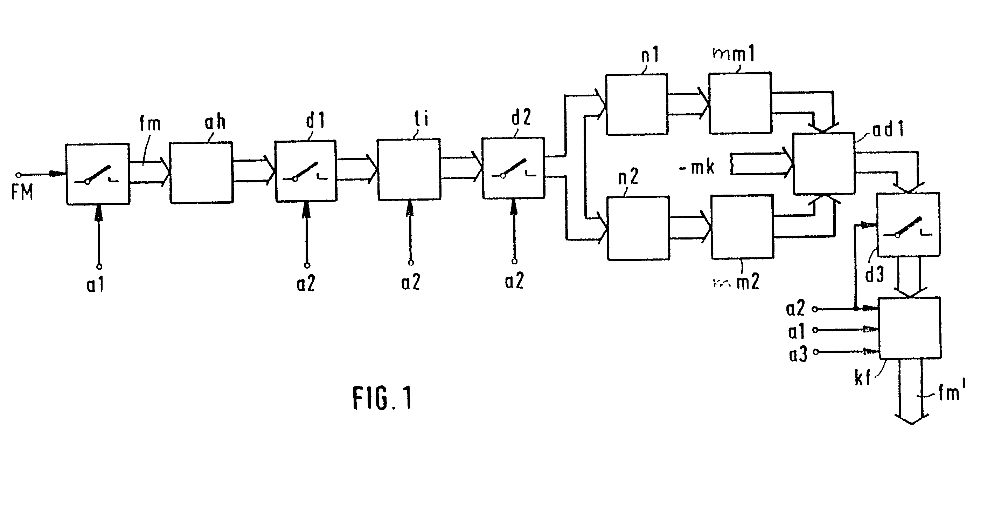

Im schematischen Blockschaltbild eines Ausführungsbeispiels der Erfindung nach Fig. 1 ist mit der ganz links liegenden Stufe, der einerseits das analoge FM-Signal FM und andererseits das erste Abtastsignal a1 zugeführt ist, angedeutet, daß das analoge PM-Signal in einer beliebigen Stufe abgetastet wird und an deren Ausgang als digitalisiertes FM-Signal fm vorliegt. Eine derartige Stufe ist im einfachsten Fall ein Analog-Digital-Wandler, es kann sich aber bei dieser Stufe auch um ein Digitalfilter gewünschter Charakteristik handeln, mit dem ein bereits analog-digital-gewandeltes PM-Signal gefiltert wird. Für die Erfindung ist lediglich von Interesse, daß ein digitalisiertes PM-Signal fm als das Eingangssignal von deren digitalem FM-Demodulator dient und daß dieses digitalisierte FM-Signal mittels des ersten Abtastsignals a1 der Prequenz f1 digitalisiert ist, d.h. daß die einzelnen Digitalworte des FM-Signals fm mit der Abtastfrequenz als Datenrate zeitlich aufeinanderfolgen.

Die digitalisierten FM-Signale fm sind der Abtasthalteschaltung ah zugeführt, deren Ausgang an der ersten Abtaststufe d1 liegt, die vom zweiten Abtastsignal a2 getaktet ist, wobei dessen Frequenz f2 ganzzahlig-vielfach höher als die Frequenz f1 des ersten Abtastsignals a1 ist und somit gilt: f2 = nf1. Während einer Periode des ersten Abtastsignals a1 werden also mittels der ersten Abtaststufe d1 n Abtastproben des Ausgangssignals der Abtasthalteschaltung ah erzeugt und somit jedes Datenwort des, FM-Signals fm in n Datenworte überführt.

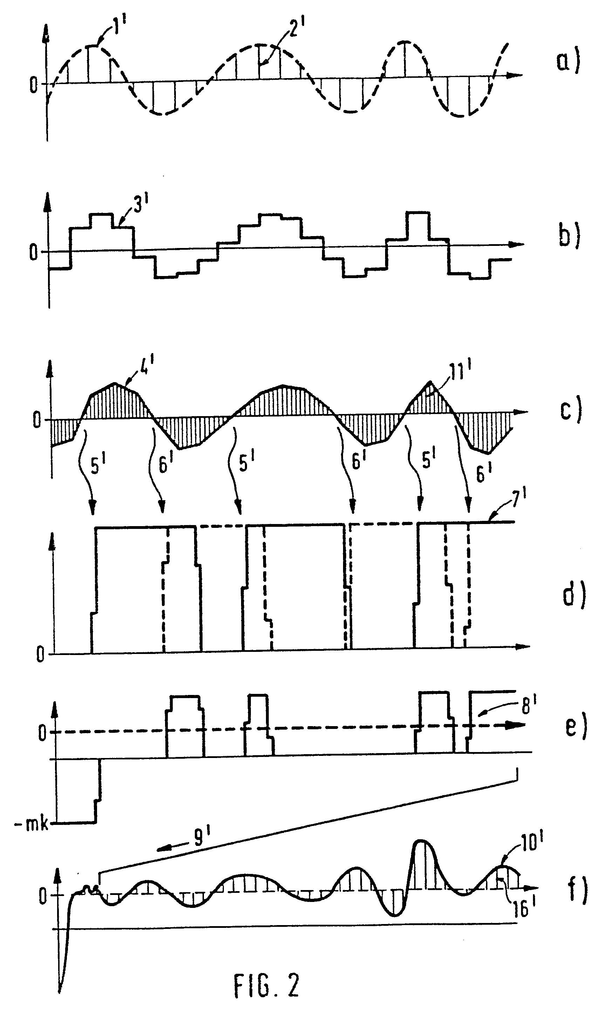

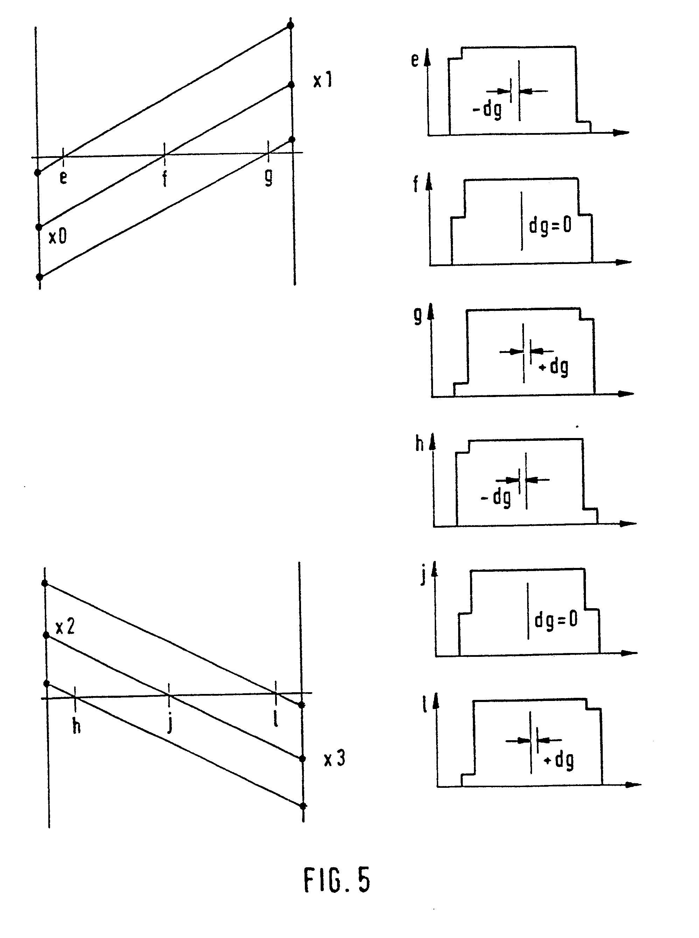

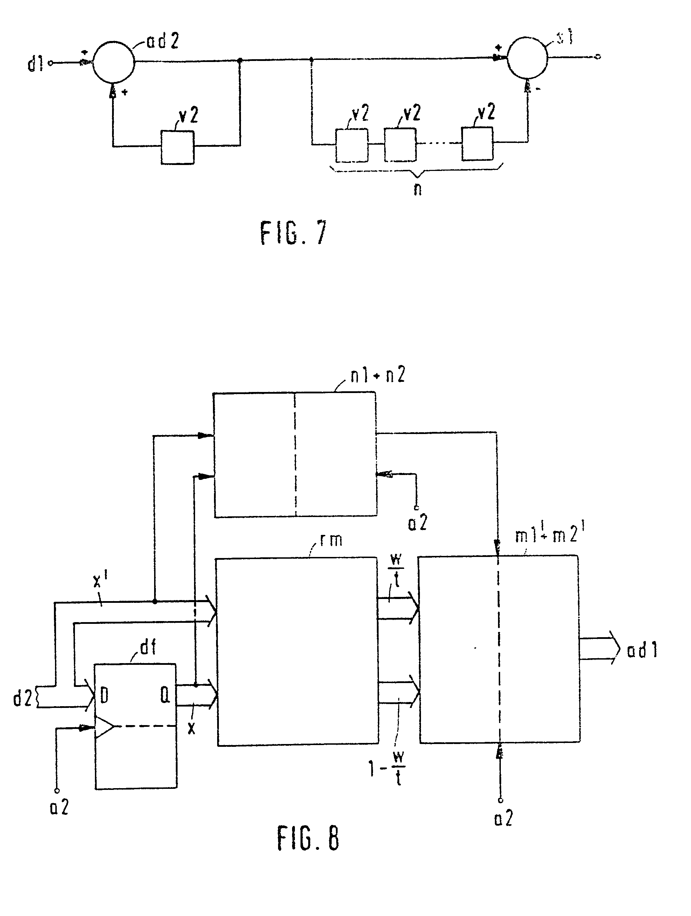

Der Ausgang der ersten Abtaststufe d1 liegt am Eingang des vom zweiten Taktsignal getakteten digitalen Interpolationsfilters ti, dessen Funktion unten im Zusammenhang mit der Erläuterung der Fig. 2 bis 4 noch näher beschrieben wird. Der Ausgang des Interpolationsfilters ti liegt am Eingang der zweiten Abtaststufe d2, die ebenfalls vom zweiten Abtastsignal a2 getaktet ist. Deren Ausgang wiederum liegt einmal am Eingang des ersten Nulldurchgangsdetektors n1 für positiv gerichtete Nulldurchgänge und andererseits am Eingang des zweiten Nulldurchgangsdetektors n2 für negativ gerichtete Nulldurchgänge. Der jeweilige Ausgang der beiden Nulldurchgangsdetektoren n1, n2 liegt am Eingang des ersten bzw. des zweiten gruppenlaufzeit-gesteuerten Monoflops mm1 bzw. mm2. Die Funktion dieser Stufen wird unten bei der Beschreibung der Fig. 5 und 6 näher erläutert.

Der Ausgang des ersten bzw. des zweiten Monoflops mm1, mm2 liegt an jeweils einem Eingang des ersten Addierers ad1, von dem ein weiterer Eingang mit dem Mittelwertkompensationssignali -mk gespeist ist. Der Ausgang des ersten Addierers ad1 liegt am Eingang der vom zweiten Abtastsignal a2 getakteten dritten Abtaststufe d3, deren Ausgang am Eingang des digitalen Konversionsfilters kf liegt. Dieses ist vom ersten, zweiten und dritten Abtastsignal a1, a2, a3 getaktet, wobei die Frequenz f3 des dritten Abtastsignals a3 ganzzahlig-vielfach kleiner als die Frequenz f2 des zweiten Abtastsignals a2 ist und somit gilt: f2 = mf3. Am Ausgang des Konversionsfilters kf ist das demodulierte digitale FM-Signal fm' abnehmbar.

Nach einer besonderen Ausführungsform der Erfindung sind das Interpolationsfilter ti und/oder das Konversionsfilter kf lineare Digitalfilter. Für diesen Sonderfall der Erfindung sind in den Fig. 2 bis 4 Kurven gezeigt, die dem besseren Verständnis der Erfindung dienen sollen. Die Darstellungsweise in diesen Figuren ist der besseren Anschaulichkeit wegen dabei im allgemeinen analog, obwohl die Signale, auf die sie sich beziehen, durchweg Digitalsignale sind. Zur Darstellungsweise in den Figuren sei ferner angemerkt, daß Bezugszeichen mit einem Apostroph auf bestimmte Kurventeile hinweisen. Die Figur 2a zeigt bei 1' den gestrichelt gezeigten Verlauf des analogen FM-Signals FM und bei 2' die daraus in der eingangs geschilderten Weise erzeugten digitalen FM-Signale fm. Der Abstand dieser digitalen Signale ist gleich dem Kehrwert der Frequenz f1 des ersten Abtastsignals a1.

Die Figur 2b zeigt den Signalverlauf am Ausgang der Abtasthalteschaltung ah und bei 3', daß das jeweilige Digitalwort des FM-Signals fm für die Periodendauer des ersten Abtastsignals a1 konstant gehalten wird. Aus den nach Fig. 2a zeitdiskret auftretenden Abtastwerten bzw. Digitalworten des FM-Signals fm wird somit die in Fig. 2b gezeigte treppenartige Kurve.

Mittels des für die Figurenerläuterung vorausgesetzten linearen Interpolationsfilters ti wird nun zwischen zwei aufeinanderfolgenden Digitalwörtern nach Fig. 2a linear interpoliert, so daß sich die bei 4' in Fig. 2c gezeigte Ausgleichskurve ergibt. Vorausgegangen ist jedoch in der ersten Abtaststufe d1 die Abtastung der treppenartigen Kurve nach Fig. 2b mittels des n-fach, frequenzhöheren zweiten Abtastsignals a2, dessen Abtastwerte in Fig. 2c bei 11' gezeigt sind. Die erwähnte Ausgleichskurve bei 4' hat nun bei 5' positiv gerichtete und bei 6' negativ gerichtete Nulldurchgänge. Diese triggern jeweils das erste bzw. zweite gruppenlaufzeit-gesteuerte Monoflop mm1, mm2.

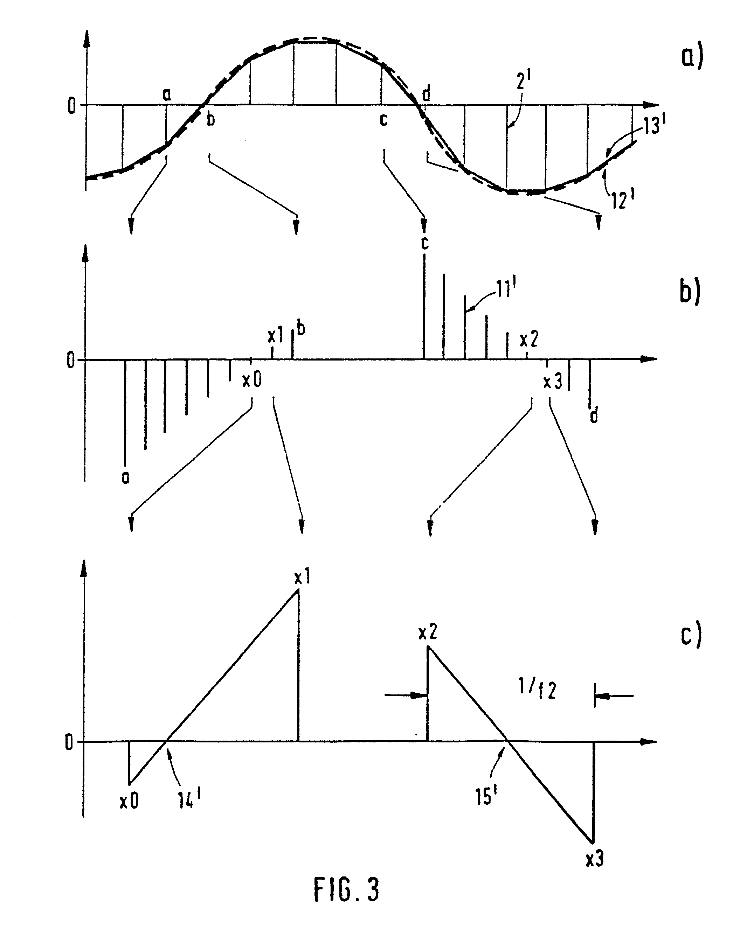

Die Fig. 3 zeigt in vergrößerter Darstellung die Funktionsweise des linearen Interpolationsfilters. In Fig. 3a liegen die Abtastwerte a, b vor und nach einem positiv gerichteten Nulldurchgang und die Abtastwerte c, d vor und nach einem negativ gerichteten Nulldurchgang. Diese Abtastwerte entsprechen den bei 2' gezeigten Abtastwerten in Fig. 2a, d.h. ihre Abtastrate entspricht der Frequenz des ersten Abtastsignals. Bei 12' ist wiederum der gestrichelte Verlauf des analogen FM-Signals gezeigt, während die ausgezogene Kurve bei 13' bereits die linear interpolierte Kurve wie in Fig 20 ist.

In Fig. 3b ist mit zeitlich vergrößertem Maßstab gezeigt, wie die bei 11' gezeigten Abtastwerte entsprechend Fig. 2c links und rechts der beiden Nulldurchgänge nach Fig. 3a liegen, wobei zwischen den Abtastwerten a, b bzw. c, d nach Fig. 3a nun die n Abtastwerte nach Fig. 2c liegen. Der Nulldurchgang liegt nun zwischen den Abtastwerten x0, x1 bzw. x2, x3.

In Fig. 3c ist nun die genaue Lage des entsprechenden Nulldurchgangs bei 14' bzw. 15' in nochmals zeitlich vergrößertem Maßstab gezeigt.

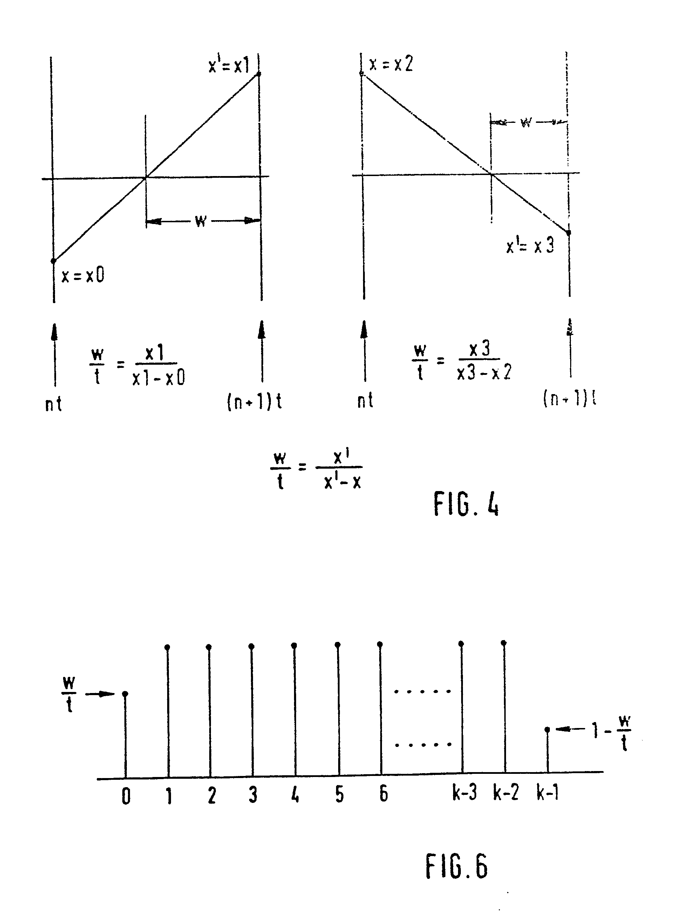

Daraus lassen sich, wie Fig. 4 zeigt, die dort angegebenen geometrischen Beziehungen ableiten. Für zwei aufeinanderfolgende Zeitpunkte nt und (n+1)t des zweiten Abtastsignals a2, in denen die Abtastwerte x0, x1 bzw. x2, x3 oder allgemein ausgedrückt x, x' auftreten, gilt die folgende Beziehung: $w/t = x'/(x'-x)$, wobei mit w der zeitliche Abstand vom tatsächlichen Nulldurchgang bis zum Zeitpunkt (n+1)t bezeichnet ist.

Die Fig. 6 zeigt schematisch die Anzahl und Amplitude der im Takt des zweiten Abtastsignals a2 auftretenden k Ausgangsimpulse des gruppenlaufzeit-gesteuerten Monoflops mm1 bzw. mm2. k ist dabei höchstens gleich dem Quotienten aus der Frequenz f2 und der höchsten auftretenden Frequenz des analogen FM-Signals FM. Die äquidistant mit gleicher Amplitude auftretenden Impulse 1 bis k-2 werden von den Impulsen 0 und k-1 "eingerahmt", deren Amplitude w/t bzw. 1-w/t entspricht. Durch diese beiden gewichteten Impulse wird erreicht, daß sich der Zeitflächen-Schwerpunkt des jeweiligen Ausgangsimpulses der beiden Monoflops mm1, mm2 zeitlich in Abhängigkeit vom Nulldurchgang kontinuierlich verschiebt, wie dies in Fig. 5 für jeweils drei Fälle e, f, g bzw. h, j, l eines positiv bzw. negativ gerichteten Nulldurchgangs gezeigt ist. Die in Fig. 5 rechts gezeigten sechs Impulsflächen sind den erwähnten Nulldurchgängen e...l zugeordnet. Die Nulldurchgänge f, j zeigen, daß am Anfang und Ende des jeweiligen Ausgangsimpulses der Monoflops ein Impuls mit der halben Maximalamplitude auftritt, d.h. daß diese Flächen symmetrische Form haben und somit der Flächenschwerpunkt auf der langen, in der Mitte der Impulsfläche gezeigten Linie liegt, welche als Nullbezugslinie für das Abweichungsmaß dg angesehen werden kann. Für die Nulldurchgänge f, j ist dg somit gleich null.

Der Nulldurchgang e bewirkt dagegen die entsprechende Impulsfläche mit einem großen (w/t)-Anfangswert und einem entsprechend kleinen Endwert und somit einer entsprechenden Abweichung -dg des Flächenschwerpunkts. In gleicher Weise bewirkt auch der Nulldurchgang h eine negative Flächenschwerpunktverlagerung.

Die Nulldurchgänge g, l haben dagegen einen niedrigen (w/t)-Anfangswert und somit einen hohen Endwert, so daß sich der Flächenschwerpunkt zu positiven Abweichungen +dg verschiebt. Mittels der entsprechend w/t modifizierten Ausgangsimpulse der gruppenlaufzeit-gesteuerten Monoflops mm1, mm2 wird also die aufgrund der zeitdiskreten Abtastung nicht genau lokalisierbare Lage der Nulldurchgänge sozusagen wieder ermittelt. Somit weist das demodulierte FM-Signal trotz Anwendung der auf mehreren Abtastungen beruhenden digitalen Prinzipien praktisch keinen Abtastfehler auf.

In Fig. 2d sind bei 7' die Umhüllenden der Ausgangsimpulse der beiden Monoflops mm1, mm2 gezeigt, wobei die den positiv gerichteten Nulldurchgängen zugeordneten Impulse mit ausgezogener Linie und die den negativ gerichteten Nulldurchgängen zugeordneten Impulse gestrichelt gezeichnet sind. Mittels des ersten Addierers ad1 wird aus diesen Impulsen zusammen mit dem Mittelwertkompensationssignal mk, das mit negativem Vorzeichen in die Addition eingeht, ein gleichwertkompensiertes Ausgangssignal entsprechend Fig. 2e erzeugt. Der Pfeil 8' soll dabei wiederum andeuten, daß innerhalb der Impulsflächen Abtastwerte mit einer der Frequenz f2 entsprechenden Abtastrate auftreten. Das Signal mk ist mit dem Quotienten aus der Trägerfrequenz und der höchsten auftretenden Frequenz des analogen FM-Signals FM identisch.

Das Ausgangssignal des ersten Addierers ad1 wird nun mittels der dritten Abtaststufe d3 wiederum im Takt der Frequenz f2 des zweiten Abtastsignals abgetastet und dann mittels des Konversionsfilters kf bandbegrenzt, wie dies mittels des Pfeils 9' in Fig. 2f gezeigt ist. Danach erfolgt eine Reduktion der Abtastrate um den Faktor m. Dies erfolgt im Konversionsfilter kf durch das dritte Abtastsignal a3, dessen Frequenz f3 um den ganzzahligen Divisor m kleiner ist als die Frequenz f2. In Fig. 2f sind bei 16' entsprechende Abtastwerte gezeigt.

Die Fig. 7 zeigt in Digitalfilter-Schaltbild-Darstellung ein bevorzugtes Ausführungsbeispiel für ein lineares Interpolationsfilter ti. Es besteht aus dem zweiten Addierer ad2, dessen einem Eingang das Ausgangssignal der ersten Abtaststufe d1 zugeführt ist und dessen anderem Eingang über das Verzögerungsglied v2 das Ausgangssignal dieses Addierers zugeführt ist. Dieses Verzögerungsglied v2 hat eine dem Reziprokwert der Frequenz f2 entsprechende Verzögerungszeit. Das Ausgangssignal des zweiten Addierers ad2 ist ferner einerseits dem Minuend-Eingang des Subtrahierers s1 und andererseits über n in Serie liegende Verzögerungsglieder v2 dem Subtrahend-Eingang zugeführt. Dieses Digitalfilter hat die Übertragungsfunktion:

$T(z) = (1-z^{-n})/(1-z^{-1})$, wobei mit z die diskrete Zeitvariable bezeichnet ist.

Die Fig. 8 zeigt schematisch als bevorzugtes Ausführungsbeispiel eine Realisierungsmöglichkeit für die Nulldurchgangsdetektoren n1, n2 und die digitalen Monoflops mm1, mm2. Zunächst ist der Festwertspeicher rm vorgesehen, in dem die lineare Interpolationsformel $w/t = x'/(x'-x)$ nach Fig. 4 abgelegt ist. Damit an den beiden Eingängen des Festwertspeichers rm zum gleichen Zeitpunkt die vor und nach einem Nulldurchgang auftretenden Signale anliegen, ist das Vielfach-D-Flipflop df vorgesehen, dessen D-Eingang das Ausgangssignal der zweiten Abtaststufe d2 zugeführt ist, während dessen Q-Ausgang, der das Signal x nach Fig. 4 führt, mit einem der Eingänge des Festwertspeichers rm verbunden ist, während dessen anderer direkt am Ausgang der zweiten Abtaststufe d2 liegt, der das Signal x' nach Fig. 4 führt. Dem Takteingang des Vielfach-D-Flipflops df ist das zweite Abtastsignal a2 zugeführt.

Die jeweilige Vorzeichenstelle des Ausgangssignals der zweiten Abtaststufe d2 bzw. des Q-Ausgangs des Mehrfach-D-Flipflops df ist mit dem entsprechenden Eingang der Nulldurchgangsdetektoren n1, n2 verbunden, denen ihrerseits jeweils der Triggereingang der digitalen Monoflops m1', m2' nachgeschaltet ist, das jeweils wieder vom zweiten Taktsignal a2 getaktet ist. Ferner sind die Signalausgänge des Festwertspeichers rm für die Signale w/t und 1-w/t mit den digitalen Monoflops m1', m2' derart gekoppelt, daß in deren jeweiligem Ausgangssignal die erwähnten Anfangsimpulse w/t und Endimpulse 1-w/t enthalten sind.

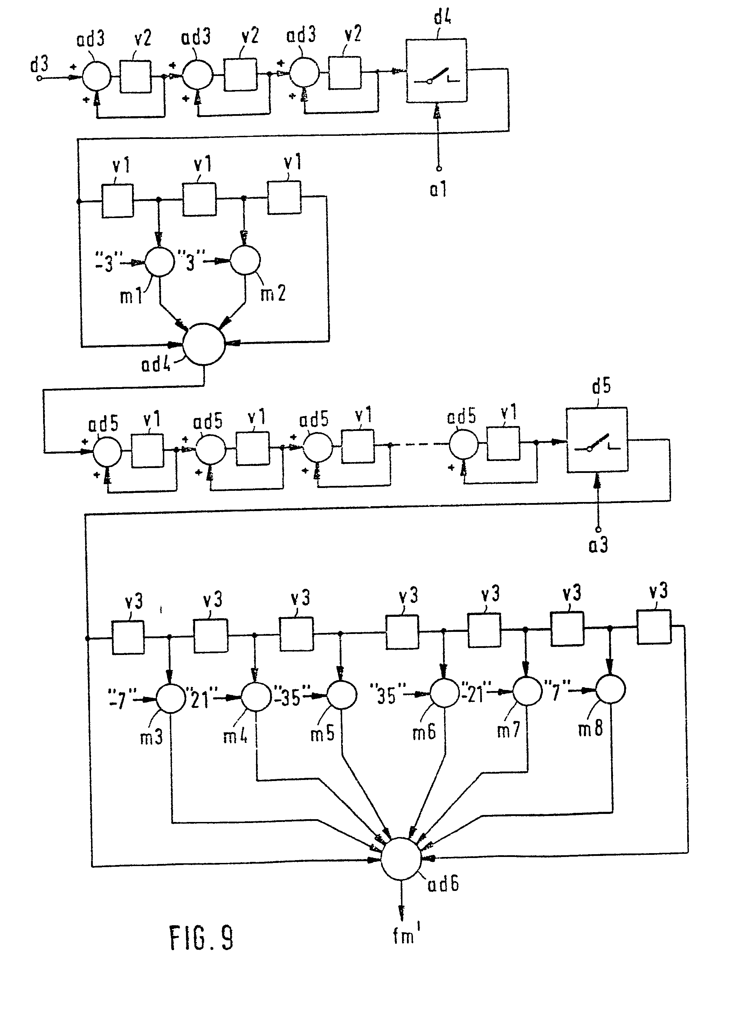

Die Fig. 9 zeigt in Form eines Digitalfilter-Schaltbilds ein erstes bevorzugtes Ausführungsbeispiel für das Konversionsfilter kf. Dieses Digitalfilter besteht aus drei Sektionen, die sich dadurch voneinander unterscheiden, daß jede von einem anderen der drei Taktsignale a1, a2, a3 getaktet ist. Die eingangsseitige erste Sektion ist vom zweiten Taktsignal a2 getaktet und besteht aus der signalflußmäßigen Serienschaltung dreier gleichartiger Teile. Davon liegt jeweils eingangsseitig der dritte Addierer ad3, dessen einer Eingang das zu filternde Signal direkt zugeführt erhält und dessen anderem Eingang über das Verzögerungsglied v2 sein Ausgangs, signal zugeführt wird. Die Verzögerungszeit des Verzögerungsglieds v2 ist wiederum gleich der Periodendauer des zweiten Abtastsignals a2. Das Ausgangssignal der Serienschaltung dreier gleichartiger Teilschaltungen ist der vierten Abtaststufe d4 zugeführt, die vom ersten Taktsignal a1 getaktet ist. Ihr Ausgang führt zur signalflußmäßigen Serienschaltung dreier Verzögerungsglieder v1, deren Verzögerungszeit gleich der Periodendauer des ersten Taktsignals a1 ist. Von den zwei mittleren Verbindungspunkten dieser Serienschaltung führt der erste bzw. zweite Multiplizierer m1, m2 zu einem der Eingänge des vierten Addierers ad4, dem auch der Eingang und der Ausgang der erwähnten Serienschaltung von Verzögerungsgliedern v1 zugeführt ist. Am jeweils zweiten Eingang der Multiplizierer m1, m2 liegt ein Signal, das dem dezimalen Zahlenwert -3 bzw. 3 entspricht, was in Fig. 9 durch die beiden Apostrophzeichen an -3 bzw. 3 angedeutet ist.

Der Ausgang des vierten Addierers ad4 führt zum Eingang der signalflußmäßigen Serienschaltung von sieben gleichartigen Teilschaltungen aus dem jeweils eingangsseitig liegenden fünften Addierer ad5 und dem diesem nachgeschalteten Verzögerungsglied v1, das wiederum als Verzögerungszeit die Periodendauer des ersten Taktsignals a1 hat und dessen Ausgang zum zweiten Eingang des fünften Addierers ad5 führt.

Vom Eingang der vierten Abtaststufe d4 bis zum Ausgang der letzten Verzögerungsstufe v1 der eben erwähnten Serienschaltung von sieben gleichartigen Stufen erstreckt sich die zweite der erwähnten Filtersektionen.

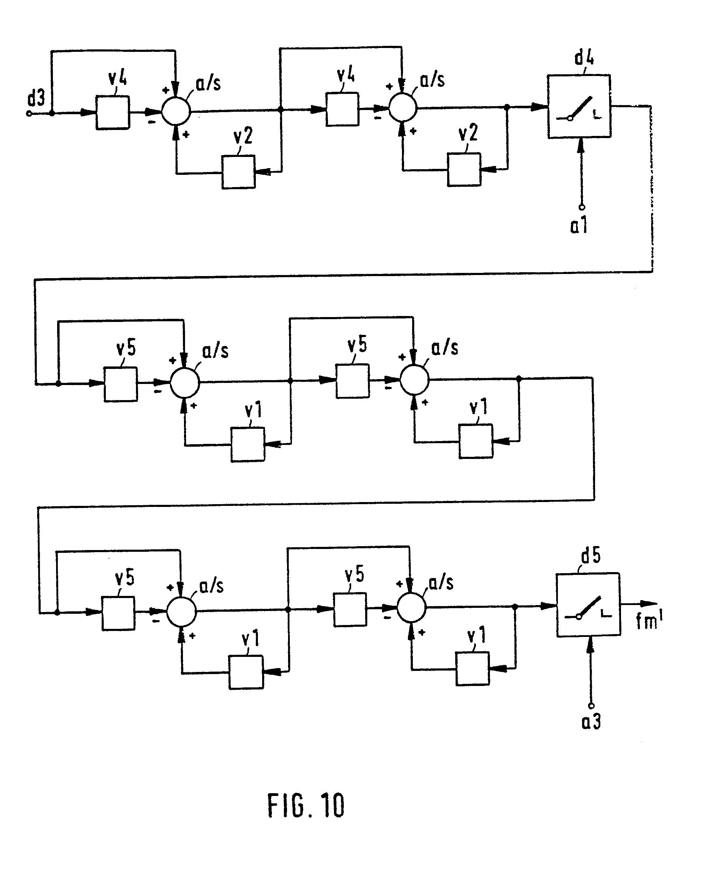

Die dritte Filtersektion beginnt mit der fünften Abtaststufe d5, die vom dritten Taktsignal a3 getaktet ist und deren Eingang am Ausgang des eben erwähnten letzten Verzögerungsglieds v1 liegt. Der Ausgang der fünften Abtaststufe d5 führt zur signalflußmäßigen Serienschaltung von sieben Verzögerungsgliedern v3 mit einer Verzögerungszeit, die gleich der Periodendauer des dritten Taktsignals a3 ist. Von den inneren Verbindungspunkten dieser Serienschaltung führen die Multiplizierer m3, m4, m5, m6, m7, m8 zu jeweils einem Eingang des sechsten Addierers ad6, wobei jeweils ein weiterer Eingang mit dem Eingang bzw. dem Ausgang der erwähnten Serienschaltung von Verzögerungsgliedern v3 verbunden ist. Den jeweils zweiten Eingängen der einzelnen Multiplizierer m3...m8 ist wiederum ein Signal zugeführt, das einem dezimalen Zahlenwert entspricht, und zwar sind in der Reihenfolge m3 bis m8 diese einzelnen Zahlenwerte die folgenden:-7; 21; -35; 35; -21; 7. Fig. 10 zeigt ein anderes Ausführungsbeispiel für die Realisierung des Konversionsfilters kf. Dieses Ausführungsbeispiel weist gegenüber dem von Fig. 9 keine Multiplizierer auf und kann daher unter Umständen zu einer einfacheren Realisierung mittels integrierter Schaltungen führen. Die vor der vierten Abtaststufe d4 liegende erste Filtersektion besteht aus zwei gleichartigen Teilschaltungen, wovon jede aus dem Verzögerungsglied v4 und dem Addierer/Subtrahierer a/s sowie dem Verzögerungsglied v2 besteht. Verzögerungsglied v4 und Addierers/Subtrahierer sind signalflußmäßig in Reihe geschaltet. Das Ausgangssignal des Verzögerungsglieds v4 ist dem Subtrahend-Eingang des Addierers/Subtrahierers a/s zugeführt, während den beiden Minuend-Eingängen das Eingangssignal bzw. das über das Verzögerungsglied v2 verzögerte Ausgangssignal des Addierers/Subtrahierers zugeführt sind. Die Verzögerungszeit des Verzögerungsglieds v4 ist gleich der 2n-fachen Periodendauer des zweiten Taktsignals a2, während die Verzögerungszeit des Verzögerungsglieds v2 gleich dessen Periodendauer ist. Die Übertragungsfunktion dieser aus zwei hintereinanderliegenden Teilschaltungen bestehenden ersten Filtersektion ist: $T(z) = (1-z^{-2n})^2 /(1-z^{-1})^2$.

Die zweite Filtersektion, beginnend mit der vierten Abtaststufe d4, besteht zusäztlich zu dieser aus der signalflußmäßigen Reihenschaltung von vier gleichartigen Teilschaltungen, die schaltbildmäßig identisch mit den Teilschaltungen der ersten Filtersektion sind, wobei jedoch Verzögerungsglieder v5 vor dem Addierer/Subtrahierer a/s und Verzögerungsglieder v1 verwendet sind. Die Verzögerungszeit des Verzögerungsglieds v5 ist dabei das m-fache der periodendauer des ersten Taktsignals a1 und die Verzögerungszeit des Verzögerungsglieds v1 gleich dieser Periodendauer.

Beim Ausführungsbeispiel nach Fig. 10 folgt auf die zuletzt erwähnte signalflußmäßige Reihenschaltung der vier gleichartigen Stufen wiederum die fünfte Abtaststufe d5, die vom dritten Abtastsignal a3 getaktet ist, und an deren Ausgang tritt das demodulierte digitale FM-Signal fm bereits auf. Die Übertragungsfunktion der zweiten Filtersektion ist wie folgt: $T(z) = (1-z^{-m})^4/(1-z^{-1})^4$.

Bei gewissen Anwendungsfällen kann es vorteilhaft sein, zwischen dem Ausgang des Interpolationsfilters ti und dem Eingang der zweiten Abtaststufe d2 einen digitalen Begrenzer anzuordnen. Im allgemeinen wird es nämlich nicht erforderlich sein, die gesamte Wortbreite des Ausgangssignals des Interpolationsfilters fi weiter zu verarbeiten. Es kann vielmehr ausreichend sein, diejenige Wortbreite weiterzuverwenden, die am Eingang des Interpolationsfilters vorhanden ist. Die Begrenzung betrifft dabei die höherwertigen Stellen des Ausgangssignals des Interpolationsfilters, da in den nachfolgenden Stufen im wesentlichen die Nulldurchgänge interessieren.

**Patentansprüche**

1. Digitaler FM-Demodulator für mittels eines ersten Abtastsignals (a1) digitalisierte FM-Signale (fm), gekennzeichnet durch folgende Merkmale:
- die FM-Signale (fm) sind einer Abtasthalteschaltung (ah) zugeführt, deren Ausgang an einer ersten Abtaststufe (d1) liegt, die von einem zweiten Abtastsignal (a2) mit ganzzahlig-vielfach höherer Frequenz (f2) als die Frequenz (f1) des ersten Abtastsignals (a1) getaktet ist, so daß gilt: f2 = nf1,
- der Ausgang der ersten Abtaststufe (d1) liegt am Eingang eines vom zweiten Taktsignal (a2) getakteten digitalen Interpolationsfilters (ti), dessen Ausgang an einer vom zweiten Abtastsignal (a2) getakteten zweiten Abtaststufe (d2) liegt,
- der Ausgang der zweiten Abtaststufe (d2) liegt am Eingang eines ersten Nulldurchgangsdetektors (n1) für positiv gerichtete Nulldurchgänge, dem ein erstes gruppenlaufzeit-gesteuertes Monoflop (mm1) nachgeschaltet ist,
- der Ausgang der zweiten Abtaststufe (d2) liegt ferner am Eingang eines zweiten Nulldurchgangsdetektors (n2) für negativ gerichtete Nulldurchgänge, dem ein zweites gruppenlaufzeit-gesteuertes Monoflop (mm2) nachgeschaltet ist und
- der Ausgang des ersten bzw. des zweiten Monoflops (mm1, mm2) liegt an jeweils einem Eingang eines ersten Addierers (ad1), von dem ein weiterer Eingang mit einem mit dem Quotienten aus der Trägerfrequenz und der höchsten auftretenden Frequenz des analogen FM-Signals (FM) identischen Mittelwertkompensationssignal (mk) gespeist ist und dessen Ausgang über eine vom zweiten Abtastsignal (a2) getaktete dritte Abtaststufe (d3) am Eingang eines vom ersten, zweiten und einem dritten Abtastsignal (a1, a2, a3) getakteten digitalen Konversionsfilters (kf) liegt, wobei die Frequenz (f3) des dritten Abtastsignals (a3) ganzzahlig-vielfach kleiner als die Frequenz (f2) des zweiten Abtastsignals (a2) ist, so daß gilt: $f2 = mf3$.

2. Digitaler FM-Demodulator nach Anspruch 1, dadurch gekennzeichnet, daß das Interpolationsfilter (ti) und/oder das Konversionsfilter (kf) linearen Digitalfilter sind.

3. Digitaler FM-Demodulator nach Anspruch 1 oder 2, dadurch gekennzeichnet, daß zwischen dem Ausgang des Interpolationsfilters (ti) und dem Eingang der zweiten Abtaststufe (d2) ein digitaler Begrenzer angeordnet ist.

4. Digitaler FM-Demodulator nach einem der Ansprüche 1 bis 3, gekennzeichnet durch folgende Merkmale:
- jedes gruppenlaufzeit-gesteuerte Monoflop (mm1, mm2) besteht aus einem beiden gemeinsamen Festwertspeicher (rm) und jeweils aus diesem nachgeschalteten digitalen Monoflop (m1', m2'),
- im Festwertspeicher (rm) sind für zwei im Abstand zweier aufeinanderfolgender Impulse des zweiten Abtastsignals (a2) auftretende Abtastwerte (x, x') als Eingangssignale die aufgrund linearer Interpolation auftretenden beiden Werte $x'/(x'-x)$ und $1-x'/(x'-x)$ als Ausgangssignale gesprichert,
- die beiden Abtastwerte (x, x') sind mittels eines Vielfach-D-Flipflops (df), an dessen Takteingang das zweite Abtastsignal (a2) liegt, aus dem Ausgangssignal der zweiten Abtaststufe (d2) gebildet,
- die Nulldurchgangsdetektoren sind eingangsseitig mit der jeweiligen Vorzeichenstelle des Ausgangssignals der zweiten Abtaststufe (d2) bzw. des Vielfach-D-Flipflops (df) und ausgangsseitig mit dem Triggereingang des jeweiligen digitalen Monoflops (m1', m2') verbunden, und
- die Ausgänge des Festwertspeichers (rm) für die Signale $x'/(x'-x)$ bzw. $1-x'/(x'-x)$ sind mit den Eingängen der digitalen Monoflops (m1', m2') derart verbunden, daß in deren jeweiligem Ausgangssignal diese beiden Signale als Anfangsimpuls bzw. Endimpuls enthalten sind.

## Claims

1. Digital FM detector for FH signals (fm) digitized by means of a first sampling signal (a1), <u>characterized by the following features:</u>
- The FM signals (fm) are fed to a sample-and-hold circuit (ah) having its output connected to a first sampling stage (d1) which is clocked by a second sampling signal (a2) at a frequency (f2) which is an integral multiple of the frequency (f1) of the first sampling signal (a1), so that $f2 = nf1$,
- the output of the first sampling stage (d1) is coupled to the input of a digital interpolating filter (ti) clocked by the second sampling signal (a2) and having its output connected to a second sampling stage (d2) clocked by the second sampling signal (a2);
- the output of the second sampling stage (d2) is coupled to the input of a first zero-crossing detector (n1) for positive-going zero crossings which is followed by a first group-delay-controlled monostable multivibrator (m1);
- the output of the second sampling stage (d2) is also coupled to the input of a second zero-crossing detector (n2) for negative-going zero-crossings which is followed by a second group-delay-controlled monostable multivibrator (m2), and
- the outputs of the first and second monostable multivibrators (m1, m2) are each couplad to one input of a first adder (ad1) an additional input of which is fed an average-value compensation signal (mk) identical with the quotient of the carrier frequency and the maximum possible frequency of the analog FM signal (FM), and the output of which is coupled through a third sampling stage (d3) clocked by the second sampling signal (a2) to the input of a digital conversion filter (kf) clocked by the first and second sampling signals (a1, a2) and a third sampling signal (a3) whose frequency (f3) is a submultiple of the frequency (f2) of the second sampling signal (a2), so that $f2 = mf3$.

2. A digital FM detector as claimed in claim 1, characterized in that the interpolating filter (ti) and/or the conversion filter (kf) are linear digital filters.

3. A digital FM detector as claimed in claim 1 or 2, characterized in that a digital limiter is inserted between the output of the interpolating filter (ti) and the input of the second sampling stage (d2).

4. A digital FM detector as claimed in any one of claims 1 to 3, characterized by the following features:
- Each of the group-delay-controlled monostable multivibrators (m1, m2) consists of a read-only memory (rm) common to both monostable multivibrators (m1, m2) and of a digital monostable multivibrator (m1', m2') following the read-only memory (rm);
- in the read-only memory (rm) for two samples (x, x') occurring as input signals at intervals of two successive pulses of the second sampling signal (a2), the two values resulting from linear interpolation, $x'/(x'-x)$ and $1-x'/(x'-x)$, are stored as output signals;
- the two samples (x, x') are derived from the output signal of the second sampling stage (d2) by means of a D flip-flop (df) whose clock input is presented with the second sampling signal (a2);
- the zero-crossing detectors have two inputs connected to the sign-bit output terminals of the second sampling stage (d2) and the D flip-flop (df), respectively, and the output of each zero-crossing detector is coupled to the trigger input of the associated digital monostable multivibrator (m1', m2'), and

- the outputs of the read-only memory (rm) for the signals x'/(x'-x) and 1-x'/(x'-x) are coupled to the inputs of the digital monostable multivibrators (m1', m2') in such a way that the output signals of the latter contain said two signals as initial pulses and final pulses, respectively.

**Revendications**

1. Détecteur FM numérique pour des signaux FM (fm) numérisés au moyen d'un premier signal d'échantillonnage (a1),
    <u>caractérisé en ce que:</u>
    - les signaux FM (fm) sont fournis à un circuit d'échantillonnage-maintien (ah) dont la sortie est connectée à un premier étage d'échantillonnage (dl) cadencé par un deuxième signal d'échantillonnage (a2) à une fréquence (f2) qui est un multiple entier de la fréquence (f1) du premier signal d'échantillonnage (a1), de sorte que f2 = nf1;
    - la sortie du premier étage d'échantillonnage (d1) est couplée à l'entrée d'un filtre d'interpolation numérique (ti) cadencé par le deuxième signal d'échantillonnage (a2), dont la sortie est connectée à un deuxième étage d'échantillonnage (d2) cadencé par le deuxième signal d'échantillonnage (a2);
    - la sortie du deuxième étage d'échantillonnage (d2) est couplée à l'entrée d'un premier détecteur de passage par zéro (n1) en provenance de niveaux positifs, qui est suivi par un premier multivibrateur monostable (mm1) commandé par le retard de groupe;
    - la sortie du deuxième étage d'échantillonnage (d2) est également couplée à l'entrée d'un deuxième détecteur de passage par zéro (n2) en provenance de niveaux négatifs, qui est suivi par un deuxième multivibrateur monostable (mm2) commandé par le retard de groupe et
    - les sorties du premier et du deuxième multivibrateurs monostables (mm1, mm2) sont chacune couplées à une entrée d'un premier additionneur (ad1) dont une entrée additionnelle reçoit un signal de compensation de valeur moyenne (mk) identique au quotient de la fréquence porteuse par la fréquence maximale possible du signal FM analogique (FM) et dont la sortie est couplée, par l'intermédiaire d'un troisième étage d'échantillonnage (d3) cadencé par le deuxième signal d'échantillonnage (a2), à l'entrée d'un filtre de conversion numérique (kf) cadencé par les premier et deuxième signaux d'échantillonnage (a1, a2) et un troisième signal d'échantillonnage (a3) dont la fréquence (f3) est un sous-multiple de la fréquence (f2) du deuxième signal d'échantillonnage (a2), de sorte que f2 = mf3.

2. Détecteur FM numérique selon la revendication 1, caractérisé en ce que le filtre d'interpolation (ti) et/ou le filtre de conversion (kf) sont des filtres numériques linéaires.

3. Détecteur FM numérique selon la revendication 1 ou 2, caractérisé en ce qu'un limiteur numérique est inséré entre la sortie du filtre d'interpolation (ti) et l'entrée du deuxième étage d'échantillonnage (d2).

4. Détecteur FM numérique selon l'une quelconque des revendications 1 à 3, caractérisé en ce que:
    - chacun des multivibrateurs monostables à commande par le retard de groupe (mm1, mm2) consiste en une mémoire morte (rm) commune aux deux multivibrateurs monostables et un multivibrateur monostable numérique (m1', m2') suivant la mémoire morte (rm), pour chacun d'eux;
    - dans la mémoire morte (rm), sont enregistrées les deux valeurs résultant de l'interpolation numérique, (x'/x'-x) et 1-x'/(x'-x), pour deux échantillons (x, x') survenant comme signaux d'entrée à l'intervalle de deux impulsions successives du deuxième signal d'échantillonnage (a2);
    - les deux échantillons (x, x') sont dérivés du signal de sortie du deuxième étage d'échantillonnage (d2) au moyen d'une bascule D (df) dont l'entrée d'horloge reçoit le deuxième signal d'échantillonnage (a2);
    - les détecteurs de passage par zéro ont leurs entrées respectivement connectées aux bornes de sortie de signe du deuxième étage d'échantillonnage (d2) et de la bascule D (df), tandis que leurs sorties sont couplées à l'entrée de déclenchement de chaque multivibrateur monostable numérique (m1', m2') et
    - les sorties de la mémoire morte (rm) pour les signaux x'/(x' - x) et 1 - x'/(x' - x) sont couplées aux entrées des multivibrateurs monostables numériques (m1', m2') de manière que les signaux de sortie de ces derniers contiennent lesdits deux signaux respectivement comme impulsions initiales et impulsions finales.

FIG. 1

FIG. 2

FIG. 3

$$\frac{w}{t} = \frac{x1}{x1-x0}$$

$$\frac{w}{t} = \frac{x3}{x3-x2}$$

$$\frac{w}{t} = \frac{x^{l}}{x^{l}-x}$$

FIG. 4

FIG. 6

FIG. 5

FIG. 7

FIG. 8

0 146 652

FIG. 9

13

FIG. 10